# FASCICULE DE BREVET EUROPEEN

(11) **EP 2 355 633 B1**
(45) Date de publication et mention de la délivrance du brevet: **13.08.2014**
(21) Numéro de dépôt: 11152939.2
(22) Date de dépôt: 01.02.2011
(51) Int. Cl.: H05K 3/34, H05K 3/30

(54) **Composant électromécanique ou électronique montable en surface**
Oberflächenmontierbares elektromechanisches oder elektronisches Bauteil
Surface mountable electromechanical or electronic device

(30) Priorité: 02.02.2010 FR 1050720
(43) Date de publication de la demande: 10.08.2011
(73) Titulaire: Apem, 82300 Caussade (FR)
(72) Inventeur: Sire, Daniel, 82240 Septfonds (FR)
(74) Mandataire: Regimbeau

(56) Documents cités:
- EP-A2- 0 471 219
- US-A- 6 012 931
- US-A1- 2005 142 907
- US-A1- 2008 128 255

## Description

### DOMAINE DE L'INVENTION

La présente invention concerne un composant électromécanique ou électronique montable en surface, comprenant des terminaisons destinées au brasage sur la surface d'une carte électronique.

### ARRIERE PLAN DE L'INVENTION

La technologie des composants montés en surface (bien connus sous l'acronyme « CMS » ou « SMD » pour « Surface Mounted Devices » selon la terminologie anglo-saxonne) désigne une technologie d'assemblage des composants sur cartes électroniques qui est largement utilisée par l'industrie électronique.

Cette technique consiste à braser les composants d'une carte à sa surface, par opposition à la technique selon laquelle les composants présentent des terminaisons traversant la carte et destinées à un brasage sur la face opposée ou sur les deux faces, et éventuellement traversant.

Les avantages de la technique CMS sont nombreux et comprennent principalement un taux d'intégration de composants plus important ainsi qu'un niveau d'automatisation de pose très élevé.

A cet effet, les composants présentent une pluralité de terminaisons métalliques destinées à être brasées par l'intermédiaire d'une de leur face, dite « face inférieure » sur la carte électronique.

Le document EP 0 471 219 décrit un tel composant.

En outre le document US 6 012 931 divulgue un composant électromécanique ou électronique selon le préambule de la revendication 1.

Cependant, la difficulté majeure de la technique CMS réside dans le fait que les réparations ou opérations de maintenance du brasage sont très délicates.

Par conséquent, pour satisfaire les exigences en termes de qualité du brasage, les différentes terminaisons d'un composant doivent présenter une excellente coplanarité de leur face inférieure, c'est-à-dire inférieure ou égale à 0,1 mm.

Or, les terminaisons sont réalisées par découpe et pliage de fines feuilles métalliques ; elles présentent donc une relative souplesse et, en fonction du lot de fabrication dont elles sont issues, d'importantes disparités de l'angle de pliage - et donc de la coplanarité - peuvent être observées.

Afin de garantir la coplanarité requise, il est donc nécessaire d'effectuer un contrôle à 100% de la coplanarité des terminaisons des composants, ce qui nécessite un matériel coûteux (système Laser par exemple) et allonge notablement la durée de production des composants.

Par ailleurs, les composants individuels sont généralement conditionnés dans des alvéoles d'un film qui est ensuite enroulé en vue de sa livraison sur le site d'assemblage.

En raison de la faible rigidité des terminaisons, celles-ci sont susceptibles de se déformer pendant leur emballage et leur transport.

Un but de la présente invention est donc de concevoir un dispositif qui permette de garantir, à faible coût, la coplanarité requise pour les terminaisons d'un composant électromécanique ou électronique destiné au montage en surface.

Un autre but de l'invention est de procurer un moyen pour éviter toute dégradation de la coplanarité des terminaisons lors de l'emballage et du transport des composants.

### BREVE DESCRIPTION DE L'INVENTION

Conformément à l'invention, il est proposé un composant électromécanique ou électronique montable en surface, comprenant des terminaisons destinées au brasage sur la surface d'une carte électronique comprenant un élément de conformation exerçant sur les terminaisons une contrainte permanente apte à rendre lesdites terminaisons coplanaires, ledit composant étant caractérisé en ce qu'il comporte un blindage rigide présentant des terminaisons destinées au brasage sur la surface de ladite carte électronique et en ce que l'élément de conformation est solidaire dudit blindage, de sorte à assurer la coplanarité des terminaisons du composant et des terminaisons du blindage.

Ledit élément de conformation comprend avantageusement un bras s'étendant transversalement par rapport aux terminaisons et en appui sur celles-ci.

Selon un mode particulier de réalisation de l'invention, ledit composant comporte en outre un blindage rigide présentant des terminaisons destinées au brasage sur la surface de ladite carte électronique, et l'élément de conformation est solidaire dudit blindage, de sorte à assurer la coplanarité des terminaisons du composant et des terminaisons du blindage.

Dans ce cas, l'élément de conformation comprend avantageusement des bras latéraux de part et d'autre du bras susmentionné, en appui sur les terminaisons du blindage.

De manière préférée, l'élément de conformation est maintenu sur le blindage par clippage.

Ledit élément de conformation comprend en outre préférentiellement un plot de centrage vis-à-vis du composant.

L'élément de conformation est par exemple réalisé en un matériau synthétique rigide.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue en perspective d'un composant conforme à l'invention,
- la figure 2 présente une vue de côté et une vue de dessus dudit composant avant que l'élément de conformation n'y soit inséré,
- la figure 3 présente une vue de dessus et une vue en coupe du composant,
- la figure 4 est une vue en perspective de l'élément de conformation.

### DESCRIPTION DETAILLEE DE L'INVENTION

On décrira, dans cet exemple non limitatif, le cas d'un micro-poussoir mais il va de soi que l'invention s'applique à tout autre composant électromécanique ou électronique montable en surface.

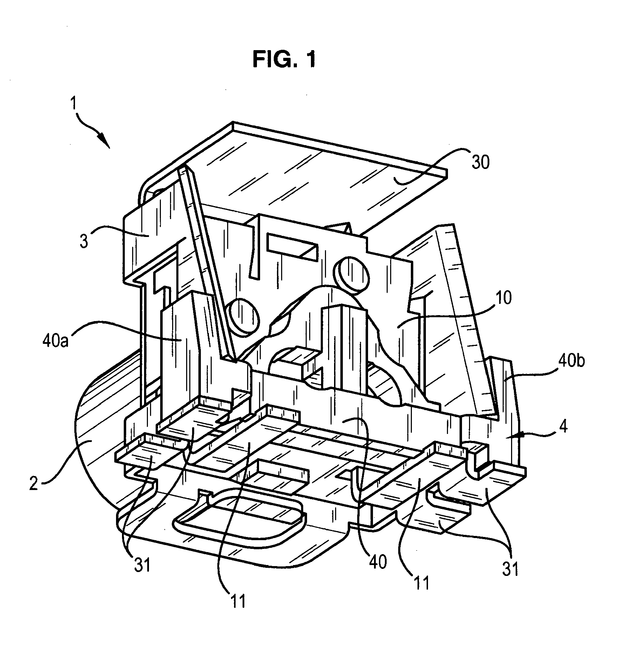

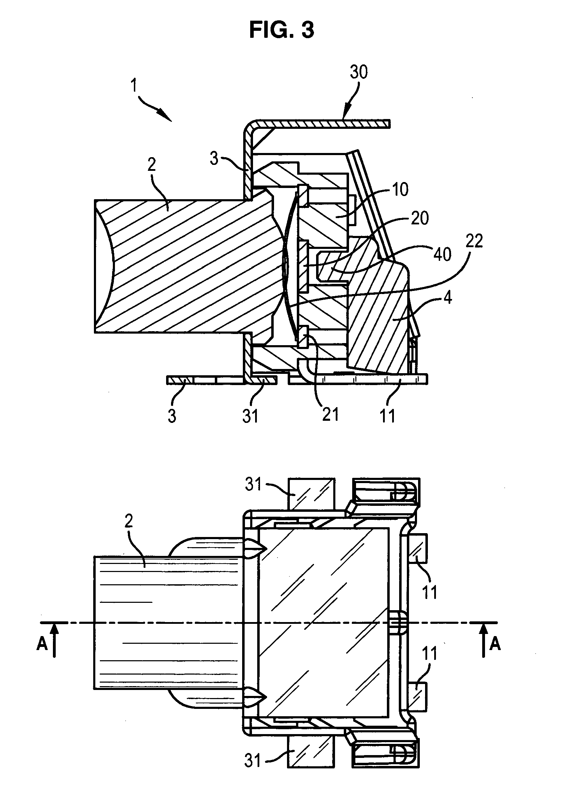

En référence aux figures 1 et 3, le composant 1 comprend un corps 10 qui supporte des contacts électriques 20, 21.

Le composant 1 comporte également un poussoir 2 qui est ici de forme cylindrique et dont l'axe est orienté parallèlement à la carte électronique (non représentée) sur laquelle le composant est destiné à être monté.

Comme on peut mieux le voir sur la vue en coupe de la figure 3, le poussoir 2 actionne une coupelle 22 de telle sorte que, lorsque le poussoir est enfoncé, les contacts 20, 21 sont reliés électriquement ensemble par l'intermédiaire de la coupelle 22 et quand le poussoir est relâché, la coupelle 22 n'assure plus de liaison électrique entre les contacts 20, 21.

Le composant comprend par ailleurs un blindage 3 qui remplit une double fonction de rigidification du composant et de préhension de celui-ci (par l'intermédiaire de la patte supérieure 30).

Sur la face inférieure du composant, le blindage 3 comporte en outre des terminaisons 31 destinées à être brasées sur la carte électronique.

On précise que les termes « inférieur » et « supérieur » sont utilisés dans le présent texte en référence à une position relative des éléments considérés selon une direction perpendiculaire à la carte électronique sur laquelle doit être brasé le composant, le terme « inférieur » se rapportant à un élément destiné à être proche de la carte électronique, le terme « supérieur » se rapportant à un élément éloigné de la carte électronique.

Le blindage 3 est réalisé en un matériau métallique rigide, avec des tolérances de fabrication très sévères, de sorte que la coplanarité des terminaisons 31 du blindage est assurée.

Le composant comprend par ailleurs des terminaisons 11, ici au nombre de deux, qui sont également destinées à être brasées sur la carte électronique.

Les terminaisons 11 sont reliées aux contacts 20, 21 et formées d'un seul tenant avec eux.

A la différence du blindage, les terminaisons 11 sont réalisées par découpe puis pliage d'une feuille métallique plus fine et/ou moins rigide et le procédé de pliage ne permet pas de garantir une parfaite reproductibilité de l'angle de pliage.

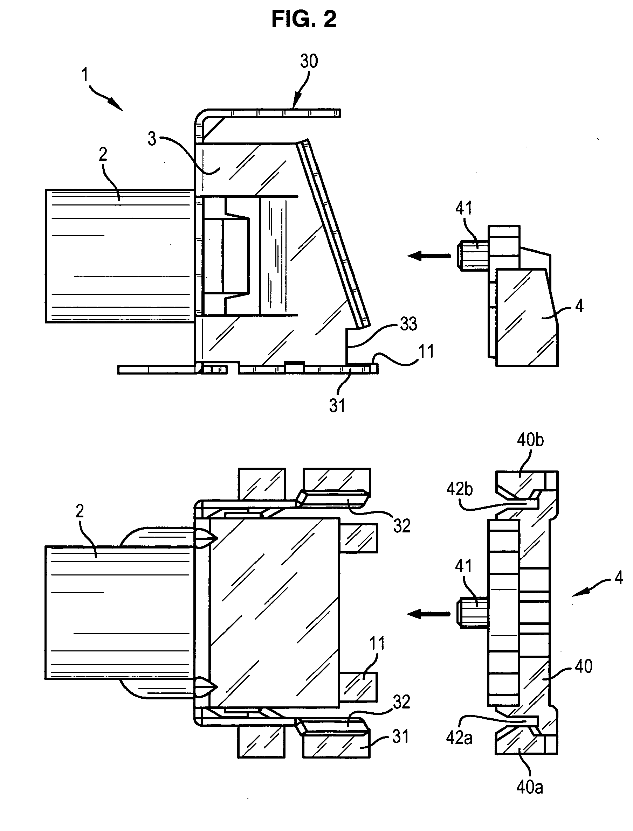

Pour assurer la coplanarité des terminaisons 31 du blindage et des terminaisons 11 du composant, on insère, à l'arrière du composant, un élément de conformation 4 (cf. figure 2).

L'élément de conformation 4 est agencé de sorte à exercer une contrainte permanente sur les terminaisons 11, ce qui permet d'assurer la coplanarité de l'ensemble des terminaisons à braser.

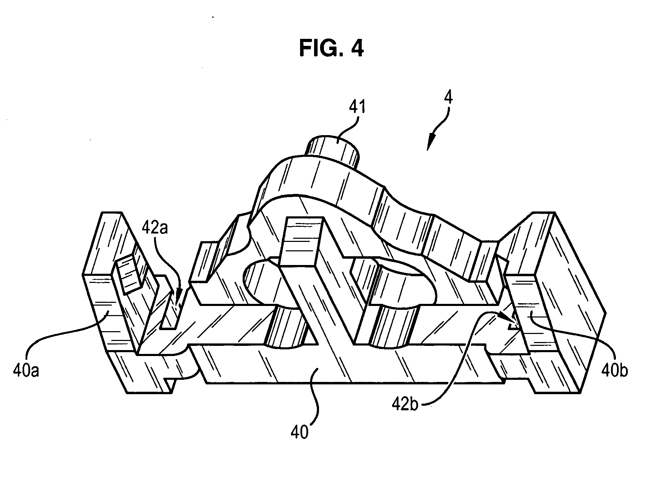

A cet effet, l'élément de conformation 4, dont une vue en perspective est présentée à la figure 4, présente un bras central 40 et deux bras latéraux parallèles 40a, 40b situés de part et d'autre du bras central 40.

Les bras 40, 40a et 40b s'étendent transversalement par rapport aux terminaisons 11 et 31, de sorte que la face inférieure des bras latéraux 40a, 40b vienne en appui sur les terminaisons 31 et le bras central 40 vienne en appui sur les terminaisons 11, les faces inférieures des bras latéraux et du bras central étant coplanaires.

Lors de la fabrication du composant, on prend soin de plier les terminaisons 11 avec un angle inférieur à 90° par rapport à un plan perpendiculaire au plan de la carte électronique, de sorte que lorsque l'élément de conformation 4 est inséré à l'arrière du composant, il ait pour effet de contraindre les terminaisons 11 vers une position parallèle au plan de la carte électronique.

Un plot 41 permet d'assurer le centrage de l'élément de conformation 4 par rapport au corps 10.

Naturellement, tout autre moyen permettant de centrer l'élément de conformation par rapport au composant pourrait être employé.

L'élément de conformation 4 est par ailleurs solidarisé par clippage en deux zones 32 du blindage, par l'intermédiaire de deux encoches 42a, 42b, jusqu'à venir en butée contre deux zones 33 (visibles à la figure 2) du blindage 3.

L'élément de conformation 4 est réalisé de préférence en un matériau isolant, typiquement, en matière plastique synthétique (par exemple, du polyamide haute température) suffisamment rigide pour exercer la précontrainte requise sur les terminaisons 11.

L'élément de conformation 4 reste sur le composant 1 pendant et après le brasage sur la carte électronique, mais, en raison de son faible poids et de son faible encombrement (puisqu'il ne dépasse pas de l'encombrement normal du composant), il ne perturbe pas la fabrication ni les performances de la carte électronique.

Par ailleurs, l'élément de conformation 4 présente l'avantage de constituer une entretoise qui évite que les terminaisons 11 ne se déforment pendant le conditionnement, le transport et la pose du composant, même en cas de chocs.

Ceci garantit qu'à l'arrivée sur le site de fabrication des cartes électroniques, et jusqu'au montage sur la carte électronique, la coplanarité des terminaisons de chaque composant soit préservée.

Enfin, il va de soi que les exemples que l'on vient de donner ne sont que des illustrations particulières en aucun cas limitatives quant aux domaines d'application de l'invention.

Ainsi, l'homme du métier sera en mesure de déterminer, en fonction du composant électromécanique ou électronique montable en surface considéré et du nombre et de la position de ses terminaisons, une géométrie appropriée pour l'élément de conformation.

De même, il pourra définir tout mode de liaison approprié pour maintenir l'élément de conformation sur le composant.

## Revendications

1. Composant électromécanique ou électronique montable en surface (1), comprenant des terminaisons (11) destinées au brasage sur la surface d'une carte électronique, comprenant un élément de conformation (4) exerçant sur les terminaisons (11) une contrainte permanente apte à rendre lesdites terminaisons (11) coplanaires, ledit composant étant **caractérisé en ce qu'**il comporte un blindage rigide (3) présentant des terminaisons (31) destinées au brasage sur la surface de ladite carte électronique et **en ce que** l'élément de conformation (4) est solidaire dudit blindage (3), de sorte à assurer la coplanarité des terminaisons (11) du composant et des terminaisons (31) du blindage.

2. Composant selon la revendication 1, **caractérisé en ce que** l'élément de conformation (4) comprend un bras (40) s'étendant transversalement par rapport aux terminaisons (11) et en appui sur celles-ci.

3. Composant selon la revendication 2, **caractérisé en ce que** l'élément de conformation (4) comprend des bras latéraux (40a, 40b) de part et d'autre du bras (40), en appui sur les terminaisons (31) du blindage.

4. Composant selon l'une des revendications 1 ou 2, **caractérisé en ce que** l'élément de conformation (4) est maintenu sur le blindage (3) par clippage.

5. Composant selon l'une des revendications 1 à 4, **caractérisé en ce que** l'élément de conformation (4) comprend un plot (41) de centrage vis-à-vis du composant.

6. Composant selon l'une des revendications 1 à 5, **caractérisé en ce que** l'élément de conformation (4) est réalisé en un matériau synthétique rigide.

## Patentansprüche

1. Oberflächenmontierbares elektromechanisches oder elektronisches Bauteil (1) mit Enden (11), die an die Oberfläche einer elektronischen Karte anzulöten sind, und mit einem Gestaltungselement (4), das einen geeigneten permanenten Druck auf die Enden (11) ausübt, um die Enden koplanar zu machen, wobei das Bauteil **dadurch gekennzeichnet ist, dass** es eine steife Kappe (3) mit Enden (31) aufweist, die an die Oberfläche der elektronischen Karte anzulöten sind, und dadurch, dass das Gestaltungselement (4) fest verbunden mit der Kappe ist (3), um so die Koplanarität der Enden (11) des Bauteils und der Enden (31) der Kappe sicherzustellen.

2. Bauteil nach Anspruch 1, **dadurch gekennzeichnet, dass** das Gestaltungselement (4) einen Arm (40) aufweist, der sich transversal bezüglich der Enden (11) und an diese anliegend erstreckt.

3. Bauteil nach Anspruch 2, **dadurch gekennzeichnet, dass** das Gestaltungselement (4) beiderseits des Arms (40) Seitenarme (40a,40b) aufweist, die an den Enden (31) der Kappe anliegen.

4. Bauteil nach Anspruch 1 oder 2, **dadurch gekennzeichnet, dass** das Gestaltungselement (4) durch eine Schnappverbindung an der Kappe (3) gehalten wird.

5. Bauteil nach einem der Ansprüche 1 bis 4, **dadurch gekennzeichnet, dass** das Gestaltungselement (4) einen Zentrierstift (41) aufweist, um es bezüglich des Bauteils zu zentrieren.

6. Bauteil nach einem der Ansprüche 1 bis 5, **dadurch gekennzeichnet, dass** das Gestaltungselement (4) aus einem steifen Kunststoffmaterial hergestellt ist.

## Claims

1. Surface-mountable electromechanical or electronic component (1), comprising terminals (11) intended for soldering onto the surface of an electronic board, comprising a shaping element (4) applying on the terminals (11) continuous stress suitable for rendering said terminals (11) coplanar, said component being **characterised in that** it comprises a rigid shielding (3) having terminals (31) intended for soldering onto the surface of said electronic board and **in that** the shaping element (4) is rigidly connected to said shielding (3), so as to ensure the coplanarity of the terminals (11) of the component and the terminals (31) of the shielding.

2. Component according to claim 1, **characterised in that** the shaping element (4) comprises an arm (40) extending transversely with respect to the terminals (11) and bearing thereon.

3. Component according to claim 2, **characterised in that** the shaping element (4) comprises lateral arms (40a, 40b) on either side of the arm (40), bearing on the terminals (31) of the shielding.

4. Component according to any of claims 1 or 2, **characterised in that** the shaping element (4) is secured on the shielding (3) by clipping.

5. Component according to any of claims 1 to 4, **characterised in that** the shaping element (4) comprises a centring contact (41) with respect to the component.

6. Component according to any of claims 1 to 5, **characterised in that** the shaping element (4) is made of a rigid synthetic material.
